# EUROPEAN PATENT APPLICATION

(11) **EP 4 822 363 A1**
(43) Date of publication of application: **14.10.2026**
(21) Application number: 26169400.4
(22) Date of filing: 31.03.2026
(51) Int. Cl.: G01R 31/11, G01R 31/00, G01R 31/08

(54) **APPARATUS AND METHOD FOR MONITORING ELECTRICAL AIRCRAFT COMPONENTS**

(30) Priority: 09.04.2025 IN 202511034860
(71) Applicant: Airbus SAS, 31700 Blagnac Cedex (FR)
(72) Inventor: BISWAS, Rajashree, Bristol, BS34 7PA (GB)
(74) Representative: Harvey, Alexander James

(57) **Abstract**

There is disclosed an apparatus for monitoring electrical aircraft components, the apparatus comprising: a pulse generator configured to transmit an electrical pulse to an electrical bus, the electrical bus being electrically connected to a plurality of loads; a pulse receiver configured to receive a reflection of the transmitted electrical pulse from the electrical bus; and a processor configured to: perform a wavelet transformation on the received reflected pulse to identify a plurality of component signals of the reflected pulse; identify an electrical condition associated with the plurality of loads based on the transformed reflection of the electrical pulse, and identify a load associated with the identified electrical condition based on a component signal associated with said load.

## Description

### FIELD OF THE INVENTION

The present invention relates to an apparatus and method for monitoring electrical aircraft components.

### BACKGROUND OF THE INVENTION

Aircraft contain many electrical systems and significant lengths of electrical wiring. Degradation of electrical wiring and systems over time is expected in all electrical systems, particularly in systems such as aircraft which are exposed to variations in pressure and temperature. As such, it is important to monitor the health of electrical systems and electrical wiring in aircraft.

The electrical systems and electrical wiring of an aircraft are typically distributed throughout the aircraft, and electrical busses are employed to provide common power and signal lines to multiple electrical loads.

Due to this arrangement, if an electrical fault or degradation of electrical components occurs, it can be difficult to identify the location of the fault. For example, a maintenance operator may be required to isolate and manually examine electrical systems at several locations in order to determine the location of an electrical fault. The aforementioned inspection processes are typically be performed while the aircraft is grounded and can be a time consuming procedure which requires downtime in the operation of the aircraft.

Thus, there is a need for a system which can monitor the health of aircraft electrical systems and electrical wiring in real-time.

### SUMMARY OF THE INVENTION

A first aspect of the invention provides an apparatus for monitoring electrical aircraft components, the apparatus comprising: a pulse generator configured to transmit an electrical pulse to an electrical bus, the electrical bus being electrically connected to a plurality of loads; a pulse receiver configured to receive a reflection of the transmitted electrical pulse from the electrical bus; and a processor configured to: perform a wavelet transformation on the received reflected pulse to identify a plurality of component signals of the reflected pulse; identify an electrical condition associated with the plurality of loads based on the transformed reflection of the electrical pulse, and identify a load associated with the identified electrical condition based on a component signal associated with said load.

Advantageously, the apparatus can monitor the electrical aircraft components (or electrical connections to the components) for the presence of electrical conditions which may include electrical faults. The apparatus is able to do so even when multiple loads are connected via a common electrical bus. This means that the apparatus may remain permanently installed on an aircraft, and a process for locating an electrical condition within complex electrical systems is simplified.

In some examples, the processor is configured to identify the load associated with the identified electrical condition based on an amplitude of the component signal associated with the electrical condition. Thus, a single apparatus as described above can monitor for the presence of electrical conditions among multiple connected electrical loads of the aircraft electrical system.

In some examples, the processor is further configured to determine a distance of the electrical condition from the pulse generator based on a time between the electrical pulse being transmitted to the electrical bus and the reflection of the electrical pulse being received by the pulse receiver; and a propagation velocity of the pulse. By accurately determining the distance to the electrical condition in this way, the location of the electrical condition can be precisely determined.

In some examples, the processor is further configured to determine said distance using time domain reflectometry, TDR.

In some examples, the electrical condition is indicative of an open circuit, a short circuit, or degradation of the associated electrical load.

In some examples, the processor is further configured to identify an open circuit based on the reflected pulse being a replica of the transmitted electrical pulse.

In some examples, the processor is further configured to identify a short circuit based on a phase difference between the reflected pulse and the transmitted electrical pulse.

In some examples, the processor is further configured to identify degradation of an electrical load based on the reflected pulse having an amplitude which is different to that of the transmitted electrical pulse.

The apparatus is thereby able to distinguish between multiple different types of electrical condition, which can support effective maintenance or repairs.

In some examples, the apparatus further comprises an impedance matching circuit electrically connected between the pulse generator and the electrical bus, the impedance matching circuit being configured to match an impedance of the plurality of electrical loads connected to the electrical bus. The apparatus can thereby determine whether any change in impedance of the aircraft component occurs, which may be indicative of an electrical condition. In particular, the change in impedance as a result of an electrical condition in the aircraft component will cause a change in the amplitude of the reflected signal.

In some examples, the apparatus is configured to periodically transmit the electrical pulse and monitor for electrical conditions based on the reflected pulse. The apparatus may thereby provide real-time health monitoring of the aircraft electrical components.

A further aspect of the invention provides an aircraft electrical system comprising: the apparatus according to any preceding statement; a plurality of electrical loads; and an electrical bus electrically connected between the apparatus and the plurality of electrical loads.

In some examples, the plurality of electrical loads comprise a fuel pump apparatus, a battery charging apparatus, and/or an auxiliary power unit, APU.

In some examples, the electrical bus is electrically connected to each of the plurality of electrical loads via a plurality of electrical wires; and the processor is configured to identify an electrical condition associated with one or more of the electrical wires based on the reflected pulse.

A further aspect of the invention provides an aircraft comprising the aircraft electrical system, wherein the apparatus is permanently installed on-board said aircraft.

A further aspect of the invention provides a method for monitoring electrical aircraft components, the method comprising: transmitting an electrical pulse to an electrical bus, the electrical bus being electrically connected to a plurality of loads; receiving a reflection of the transmitted electrical pulse from the electrical bus; performing a wavelet transformation on the received reflected pulse to identify a plurality of component signals of the reflected pulse; identifying an electrical condition associated with the plurality of loads based on the transformed reflection of the electrical pulse, and identifying a load associated with the identified electrical condition based on a component signal associated with said load.

In some examples, the method is performed during one or more aircraft flight phases. Thus, electrical conditions existing in the aircraft electrical components can be detected without needing to ground the aircraft.

A further aspect of the invention provides a monitoring system for an aircraft, the monitoring system being configured to: transmit an electrical signal to an aircraft busbar, the aircraft busbar being electrically connected to a plurality of loads of the aircraft; receive a reflection of the electrical signal from the aircraft busbar; determine a location of an electrical fault present in the plurality of loads of the aircraft based on the reflected electrical signal and time domain reflectometry, TDR, perform a wavelet transformation on the reflected electrical signal to identify component signals associated with respective loads; and analyse said component signals to identify the load associated with the electrical fault.

### BRIEF DESCRIPTION OF THE DRAWINGS

Embodiments of the invention will now be described with reference to the accompanying drawings, in which:
Figure 1 shows a schematic plan view of an aircraft;
Figure 2 shows an apparatus for monitoring electrical aircraft components;
Figure 3 shows a representation of signal reflections received in response to transmitting an electrical signal to an aircraft electrical system;
Figure 4 shows an apparatus for monitoring electrical aircraft components in accordance with an embodiment of the present invention; and
Figure 5 shows a flow chart illustrating a method for monitoring electrical aircraft components.

### DETAILED DESCRIPTION OF EMBODIMENT(S)

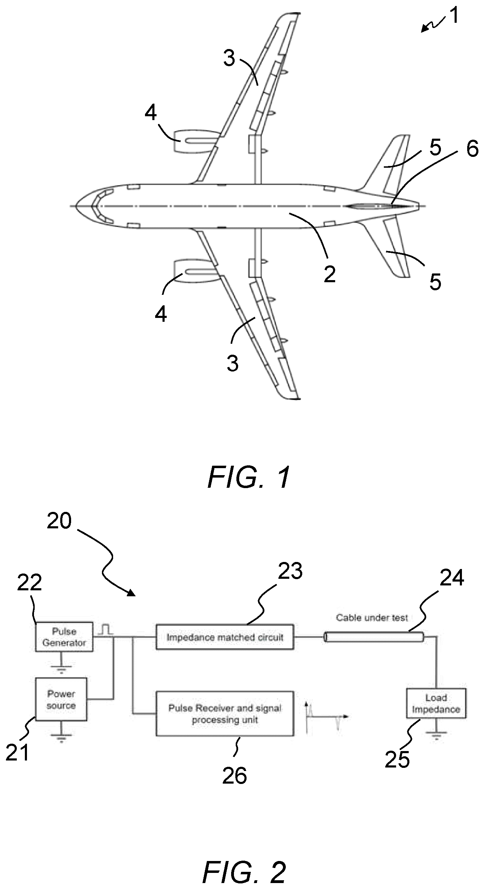

Figure 1 shows an aircraft 1. The aircraft 1 has a fuselage 2, and starboard and port fixed wings 3. An engine 4 is mounted to each wing 3. The aircraft 1 also comprises an empennage (or tail assembly) which includes starboard and port horizontal stabilisers 5 and a vertical stabiliser 6.

In the embodiment illustrated in Figure 1, the aircraft 1 is a typical jet passenger transport aircraft but the invention is applicable to a wide variety of fixed wing aircraft types, including commercial, military, passenger, cargo, jet, propeller, general aviation, etc. with any number of engines 4 attached to the wings 3 or fuselage 2.

The fuselage 2, wings 3, engines 4 and empennage of the aircraft 1 are each made up of a plurality of aircraft components which may include various electrical components of the aircraft 1. The electrical aircraft components may be connected to each other and to power supplies via one or more electrical busses, or busbars. The electrical aircraft components may be distributed around the aircraft 1.

Figure 2 shows an apparatus 20 for monitoring the health of an electrical aircraft component 24. The apparatus 20 in Figure 2 comprises a power source 21, a pulse generator 22, an impedance matched circuit 23, an electrical cable 24 to be tested which is electrically connected to an electrical load 25 having an associated impedance, and a pulse receiver 26.

The power source 21 is configured to supply electrical power to the other components of the apparatus 20. The power source 21 may further supply electrical power to one or more aircraft systems, and may comprise a battery or generator.

The pulse generator 22 is configured to transmit an electrical pulse to the electrical cable 24 via the impedance matched circuit 23. The electrical pulse may be transmitted at a specified periodicity, and may have a predetermined amplitude and/or frequency. The electrical pulse generated by the pulse generator 22 may be a low voltage, high frequency signal which does not interfere with normal operation of the aircraft 1.

The impedance matched circuit 23 is electrically connected between the pulse generator 22 and the electrical cable 24 being tested. The impedance matched circuit 23 is configured so as to have an impedance corresponding to that of a load 25 electrically connected to the electrical cable 24.

The apparatus 20 further comprises a pulse receiver 26. The pulse receiver 26 is configured to receive a reflection of the electrical pulse transmitted by the pulse generator 22. The pulse receiver 26 is also configured to directly receive the electrical pulse transmitted by the pulse generator 22.

The apparatus 20 is arranged to monitor the health of the electrical cable 24 based on reflections of the electrical pulse transmitted by the pulse generator 22 using time domain reflectometry (TDR). TDR is a known method for determining the length of an electrical cable and can also be used to monitor the health of the electrical cable 24. In particular, when an electrical signal is sent from the pulse generator 22 to the load 25 via the impedance matched circuit 23 and the electrical cable 24, any reflections of the transmitted electrical signal can be detected by the pulse receiver 26 and processed to determine whether an electrical condition exists in the electrical cable 24 and/or in the load 25. The reflections of the signal may be indicative of an electrical condition such as a fault or degradation of the electrical cable 24 or the load 25.

The apparatus 20 may further comprise a processor, which may be included as part of the pulse receiver 26 or which may be provided separately. The processor may be configured to control the operation of the pulse generator 22 and/or process the reflected signal detected by the pulse receiver 26 to identify the location of an electrical condition. The processor may further be communicatively coupled to an aircraft system or external devices and may be configured to output information about a detected electrical condition.

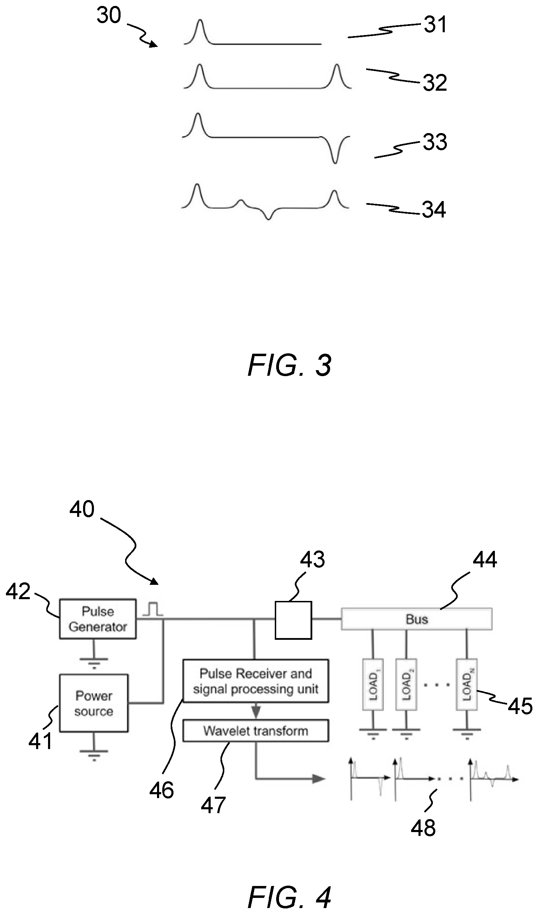

The type of electrical condition can be determined based on the received reflected signal. Turning to Figure 3, there are illustrated several representative signals 30 indicative of reflected signals that could be associated with various electrical conditions that may exist in an electrical system.

In the first representative signal 31, a first peak is shown which corresponds to the electrical pulse transmitted by the pulse generator 22. As no other peaks are detected in the first representative signal 31, the apparatus 20 may determine that no reflections have been received and that the electrical cable 24 and the load 25 are operating correctly.

In the second representative signal 32, a second peak is detected which is a replica of the first peak. The first peak corresponds to the electrical pulse transmitted by the pulse generator 22. As the second peak is a replica of the first peak, it can be determined that an open circuit exists in the electrical cable 24 or in the load 25.

In the third representative signal 33, a second peak is detected which is 180° out of phase with the transmitted signal. In this case, it can be determined that a short circuit exists in the electrical cable 24 or in the load 25.

In the fourth representative signal 34, the reflected signal comprises several peaks which do not correspond to the initial peak associated with the transmitted signal. In this case, it can be determined that an impedance mismatch exists, which may be indicative of electrical conditions such as corrosion, cable wear, or insulation failure in the electrical cable 24 or in the load 25.

The apparatus 20 of Figure 2 may therefore identify an electrical condition based on the reflections of the transmitted electrical pulse. Further, a distance between the signal generator 22 and/or the pulse receiver 26 and the electrical condition may be determined based on a time between the transmission of the electrical pulse and the detection of the reflection. The propagation velocity of the electrical pulse may be known, and therefore the distance between the electrical condition (such as an electrical fault, as discussed in Figure 3) and the apparatus 20 may be determined.

However, while the apparatus 20 of Figure 2 may identify an electrical condition and determine a distance from the pulse generator 22 and/or receiver 26 to the electrical condition such as an electrical fault in the electrical cable 24 or the load 25, it can become difficult to accurately determine the location of such electrical conditions when multiple loads are connected via a common electrical bus (or busbar), particularly when the multiple loads are connected via electrical cables arranged in parallel. In these types of systems where multiple loads are connected in parallel to a common electrical bus, the electrical signal generated by the pulse generator 26 would propagate through the parallel electrical pathways connected to the common bus, and each load may reflect a different signal. However, the multiple reflected signals may be detected as one combined signal, and it may not be possible to differentiate between different loads. As such, multiple sensing points may be required. That is, the apparatus 20 of Figure 2 may need to be deployed at multiple points around the system to determine the location of the electrical condition.

Figure 4 illustrates an apparatus 40 for monitoring the health of an aircraft electrical system in accordance with an embodiment of the present invention.

The apparatus 40 of Figure 4 also comprises a power source 41, a pulse generator 42, and a pulse receiver 46. The apparatus 40 may further comprise an electrical bus 44 to which a plurality of loads 45 are connected by respective electrical wiring. The apparatus 40 may comprise an impedance matched circuit 43 configured to match an impedance of the plurality of loads 45.

The apparatus 40 of Figure 4 may be permanently installed on-board an aircraft or may be temporarily connected to the aircraft electrical system. The bus 44 may be an electrical busbar of an aircraft, and the plurality of loads 45 may comprise electrical systems of the aircraft. The plurality of loads may include electrical component which make up, for example, a fuel pump apparatus, a battery charging apparatus, or an auxiliary power unit, APUs, of the aircraft. It should be understood that the apparatus 40 may be connected via one or more electrical busses 44 to a variety of aircraft loads.

In addition, the apparatus 40 of Figure 4 may comprise a processor 47 for applying a wavelet transformation to the reflected signal detected by the pulse receiver 46. A wavelet transformation should be understood as a mathematical technique which, when applied to a signal, separates the signal into a plurality of component signals. Wavelet transformations are particularly useful for analysing signals that have sharp changes, such as edges in images or sudden spikes in time-series data. In this case, the processor 47 is configured to apply the wavelet transformation to the received reflected signal to separate the received reflected signal into a plurality of component signals 48.

Each of the component signals may correspond to a respective load among the plurality of loads 45. The processor 47 may be configured to identify an electrical condition associated with the plurality of loads 45 based on the transformed reflection of the electrical pulse and identify a first load associated with the identified electrical condition based on a first component signal associated with the first load. That is, the processor 47 may be configured to determine which load among the plurality of loads 45 is associated with an electrical condition. It should be understood that the electrical condition being associated with a particular load may also include the electrical condition being associated with electrical wiring extending between the bus 44 and the load.

The electrical condition may be a degradation of electrical wiring or components, or an open or short circuit, and the processor 47 may be configured to distinguish between the different types of electrical condition based on the reflection of the transmitted electrical pulse, as discussed in respect of Figure 3.

The processor 47 may further be configured to identify the first load associated with the identified electrical condition based on an amplitude of the first component signal associated with the electrical condition. That is, the processor 47 may distinguish between component signals 48 associated with respective loads among the plurality of loads 45 based on the amplitude of the component signals 48. As each load will be associated with a different impedance, the amplitude of the reflected signals will vary. The processor 47 may therefore determine which component signal 48 is associated with which load 45 based on the amplitude of the reflected signal. Further, the time of arrival of the received signal component corresponding to each connected load will also differ slightly. As such, the time difference of arrival of the component signals can be additionally or alternatively used to identify the corresponding load 45. It should be understood that while this difference in the time of arrival may be small, the wavelet transform algorithm will be able to identify it.

The processor 47 may further be configured to determine a distance of the electrical condition from the pulse generator 42 based on a time between the electrical pulse being transmitted to the bus 44 and the reflection of the electrical pulse being received by the pulse receiver 46. The processor 47 may further make this determination based on a propagation velocity of the pulse, which may be known or preconfigured based on the materials used in the aircraft electrical system. In one example, the electrical pulse may propagate through the electrical system at a speed of approximately 0.66 times the speed of light, or 1.9x10⁸ m/s.

The processor 47 may be configured to determine the distance between the electrical condition and the pulse receiver 46 or pulse generator 42 using time domain reflectometry (TDR). The pulse receiver 46 and pulse generator 42 may be located in substantially the same location, and the forward travel time of the electrical pulse may be substantially equal to the travel time of the reflected signal, or the distances between the pulse receiver 46 and pulse generator 42 may be accounted for by the processor 47.

As exemplified in respect of Figure 3, the processor 47 may be configured to determine that the bus 44 and the plurality of loads 45 are operating as normal if there is no reflection of the transmitted signal detected. The processor 47 may be further configured to identify an open circuit based on the reflected pulse being a replica of the transmitted electrical pulse. The processor 47 may be further configured to identify a short circuit based on a phase difference between the reflected pulse and the transmitted electrical pulse. The processor 47 may be further configured to identify degradation of an electrical load based on the reflected pulse having a different amplitude to the transmitted electrical pulse.

The pulse generator 42 may be configured to periodically transmit the electrical pulse, and the processor 47 may be configured to monitor for electrical conditions based on the reflected pulse. For example, the apparatus 40 may be permanently installed on-board an aircraft 1, and may allow for real-time health monitoring of the aircraft 1 electrical systems. The apparatus 40 may further be configured to provide an output indicative of any detected electrical conditions, along with information relating to a location of the detected electrical condition, to the aircraft operator (or pilot).

It should be understood that where reference is made to the processor 47 of Figure 4, one or more processors may be used. For example, the processor 47 of Figure 4 may only perform the wavelet transformation, and may output separate component signals 48 to one or more external processors or devices to perform the identification of the respective loads 45 associated with each component signal 48, the assessment of the electrical condition, and/or the determination of the location of the electrical condition. Alternatively, a single processor 47 may perform each of these functions.

The apparatus 40 of Figure 4 may therefore provide effective, real-time health monitoring of aircraft electrical systems. The apparatus 40 can be permanently installed on-board an aircraft 1, and can monitor a plurality of loads 45 for electrical conditions by separating the reflected signal into component signals corresponding to each load.

The distance of the electrical condition can be determined based on a time taken for the reflected signal to propagate to the pulse receiver 46, and the location of the electrical condition can thereby be determined.

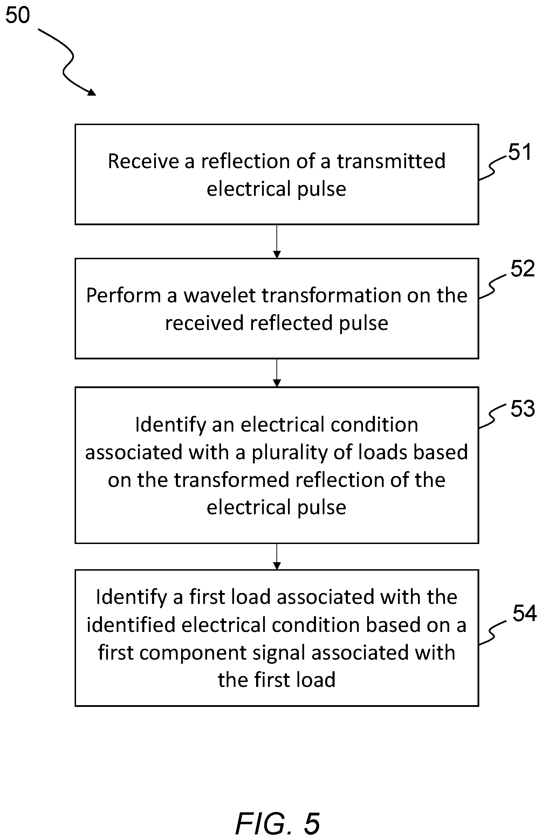

Figure 5 is a flowchart illustrating a method 50 for monitoring the health of electrical aircraft components. The method 50 of Figure 5 may be performed by the apparatus 40 of Figure 4, and particularly by the pulse generator 42, the pulse receiver 46, and the processor 47.

The method 50 includes receiving 51 a reflection of a transmitted electrical pulse. The electrical pulse may be transmitted by a pulse generator 42 to a bus 44. The bus may be electrically connected to a plurality of loads 45, which may be electrical systems of the aircraft 1. The electrical pulse may be a signal which is periodically transmitted by the pulse generator 42, and may be a low voltage, high frequency signal so as to not interfere with the regular operation of the aircraft loads 45.

The method 50 comprises performing 52 a wavelet transformation on the received reflected pulse. As explained above in respect of Figure 4, the wavelet transformation may be a mathematical operation to separate the received reflected pulse into a plurality of component signals 48. The plurality of component signals 48 may correspond to a respective load 45.

The method 50 comprises identifying 53 an electrical condition associated with the plurality of loads 45 based on the transformed reflection of the electrical pulse. That is, the method 50 may comprise processing the received reflected signal to determine whether one or more electrical conditions exist in the aircraft 1. The one or more electrical conditions may be identified based on a form of the received reflected signal, as discussed in Figure 3. The method 50 may comprise identifying a type of the electrical condition based on the form of the received reflected signal.

The method 50 comprises identifying 54 a first load associated with the identified electrical condition based on a first component signal associated with the electrical condition. That is, the method 50 may comprise determining which of the component signals 48 is indicative of an electrical condition, and then determining which of the plurality of loads 45 corresponds to the component signal which indicates the presence of an electrical condition.

The method 50 may further comprise identifying a distance of the electrical condition from the pulse generator 42 and/or the pulse receiver 46 based on a time between the electrical pulse being transmitted to the aircraft bus 44 and the reflected pulse being received by the pulse receiver 46, and further based on a propagation velocity of the electrical pulse through the aircraft bus 44. The method 50 may further comprise determining a location of the identified electrical condition based on the determined distance.

The method 50 may be performed during scheduled maintenance of an aircraft 1 or may be performed periodically or continuously during operation of the aircraft 1 (e.g., in-flight). As the apparatus 40 and the method 50 may be used to detect electrical conditions among a plurality of loads 45 connected via a common bus 44, the method 50 may be performed continuously without the need to relocate the apparatus 40. As such, the electrical components of the aircraft 1 may be monitored in real-time and during operation of the aircraft 1. The method 50 may further comprise outputting an indication of one or more identified electrical conditions in an aircraft operator (e.g., pilot) or a ground maintenance engineer. The indication may include information relating to the location of the identified electrical condition or the type of electrical condition which has been identified.

Where the word 'or' appears this is to be construed to mean 'and/or' such that items referred to are not necessarily mutually exclusive and may be used in any appropriate combination.

Although the invention has been described above with reference to one or more preferred embodiments, it will be appreciated that various changes or modifications may be made without departing from the scope of the invention as defined in the appended claims.

## Claims

1. An apparatus for monitoring electrical aircraft components, the apparatus comprising:
a pulse generator configured to transmit an electrical pulse to an electrical bus, the electrical bus being electrically connected to a plurality of loads;
a pulse receiver configured to receive a reflection of the transmitted electrical pulse from the electrical bus; and
a processor configured to:
perform a wavelet transformation on the received reflected pulse to identify a plurality of component signals of the reflected pulse;
identify an electrical condition associated with the plurality of loads based on the transformed reflection of the electrical pulse, and
identify a load associated with the identified electrical condition based on a component signal associated with said load.

2. The apparatus according to claim 1, wherein the processor is configured to identify the load associated with the identified electrical condition based on an amplitude of the component signal associated with the electrical condition and/or a time of arrival of the component signal associated with the electrical condition.

3. The apparatus of any preceding claim, wherein the processor is further configured to determine a distance of the electrical condition from the pulse generator based on:
a time between the electrical pulse being transmitted to the electrical bus and the reflection of the electrical pulse being received by the pulse receiver; and
a propagation velocity of the pulse; and
optionally, wherein the processor is further configured to determine said distance using time domain reflectometry, TDR.

4. The apparatus according to any preceding claim, wherein the electrical condition is indicative of an open circuit, a short circuit, or degradation of the associated electrical load.

5. The apparatus according to any preceding claim, wherein the processor is further configured to identify an open circuit based on the reflected pulse being a replica of the transmitted electrical pulse.

6. The apparatus according to any preceding claim, wherein the processor is further configured to identify a short circuit based on a phase difference between the reflected pulse and the transmitted electrical pulse.

7. The apparatus according to any preceding claim, wherein the processor is further configured to identify degradation of an electrical load based on the reflected pulse having an amplitude which is different to that of the transmitted electrical pulse.

8. The apparatus according to any preceding claim, further comprising an impedance matching circuit electrically connected between the pulse generator and the electrical bus, the impedance matching circuit being configured to match an impedance of the plurality of electrical loads connected to the electrical bus.

9. The apparatus according to any preceding claim, wherein the apparatus is configured to periodically transmit the electrical pulse and monitor for electrical conditions based on the reflected pulse.

10. An aircraft electrical system comprising:
the apparatus according to any preceding claim;
a plurality of electrical loads; and
an electrical bus electrically connected between the apparatus and the plurality of electrical loads.

11. The aircraft electrical system according to claim 10, wherein the plurality of electrical loads comprise a fuel pump apparatus, a battery charging apparatus, and/or an auxiliary power unit, APU.

12. The electrical system according to claims 10 or 11, wherein the electrical bus is electrically connected to each of the plurality of electrical loads via a plurality of electrical wires; and
wherein the processor is configured to identify an electrical condition associated with one or more of the electrical wires based on the reflected pulse.

13. An aircraft comprising the aircraft electrical system according to any of claims 10 to 12, wherein the apparatus is permanently installed on-board said aircraft.

14. A method for monitoring electrical aircraft components, the method comprising:
transmitting an electrical pulse to an electrical bus, the electrical bus being electrically connected to a plurality of loads;
receiving a reflection of the transmitted electrical pulse from the electrical bus;
performing a wavelet transformation on the received reflected pulse to identify a plurality of component signals of the reflected pulse;
identifying an electrical condition associated with the plurality of loads based on the transformed reflection of the electrical pulse, and
identifying a load associated with the identified electrical condition based on a component signal associated with said load.

15. The method according to claim 14, wherein the method is performed during one or more aircraft flight phases.
